# FASCICULE DE BREVET EUROPEEN

(11) **EP 1 538 514 B1**
(45) Date de publication et mention de la délivrance du brevet: **30.07.2008**
(21) Numéro de dépôt: 03027566.3
(22) Date de dépôt: 01.12.2003
(51) Int. Cl.: G06F 3/033

(54) **Substrat transparent à électrodes invisibles et dispositifs l'incorporant**
Transparantes Substrat mit unsichtbaren Elektroden und Vorrichtungen mit diesem Substrat
Transparent substrate with invisible electrodes and devices incorporating the same

(43) Date de publication de la demande: 08.06.2005
(73) Titulaire: ASULAB S.A., 2074 Marin (CH)
(72) Inventeur: Poli, Gian-Carlo, 2206 Les Geneveys-sur-Coffrane (CH); Grupp, Joachim, 2073 Enges (CH); Baroni, Pierre-Yves, 2013 Colombier (CH)
(74) Mandataire: Thérond, Gérard Raymond

(56) Documents cités:
- WO-A-93/19479
- DE-A- 3 236 099
- US-B1- 6 225 577

## Description

La présente invention a pour objet un substrat transparent ayant au moins une face pourvue d'électrodes transparentes dont la structuration est telle que leurs contours ne peuvent pas être perçus par un observateur dans le domaine de longueurs d'ondes de la lumière visible.

L'invention concerne également des dispositifs, généralement des appareils électroniques, comportant un ou plusieurs substrats transparents à électrodes invisibles dans lesquels les électrodes ont des rôles de commandes ou de collecteurs d'énergie, et plus particulièrement de tels dispositifs disposés au-dessus de l'affichage d'un appareil électronique sur lequel on doit pouvoir lire les informations dudit affichage, sans être gêné par la structuration et l'agencement des électrodes.

L'invention concerne également un procédé permettant d'effectuer, de façon économique et avec une grande précision, une structuration des électrodes sur un substrat transparent quelconque tout en procurant une compensation optique entre les électrodes permettant de rendre leurs contours invisibles.

Des solutions ont déjà été proposées pour que l'interface constituée par des électrodes disposées entre un affichage et un observateur reste la plus discrète possible et ne nuise pas à l'aspect esthétique de l'appareil électronique, notamment dans le cas d'une pièce d'horlogerie. On connaît par exemple des montres-bracelets dont la face intérieure de la glace comporte des électrodes permettant une commande tactile des fonctions horaires ou non horaires par effet capacitif ou résistif, comme cela est décrit de façon non limitative dans les brevets US 4,228,534, EP 0 674 247 et EP 1 207 439. La glace peut également être remplacée ou complétée par une cellule formée de deux substrats à électrodes transparents entre lesquels est placé un matériau actif, par exemple pour former une cellule photovoltaïque constituant la source d'énergie comme décrit dans le document WO 93/19479, ou pour former une cellule à cristaux liquides pouvant avoir un état transparent et un état permettant d'afficher sur demande des informations complémentaires ou différentes de celles affichées sur un cadran sous-jacent, comme décrit dans le document WO 99/32945.

Pour réaliser les électrodes on utilise de façon connue des oxydes conducteurs transparents (TCO), c'est-à-dire des matériaux qui sont à la fois bon conducteurs et transparents dans le visible, tels que l'oxyde d'étain et d'indium (ITO), In₂O₃ ou SnO₂ dopé à l'antimoine. On peut également utiliser comme film conducteur servant à la structuration des électrodes des polymères conducteurs transparents qui sont des composés organiques à doubles liaisons conjuguées dont la conductivité peut être améliorée par dopage chimique ou électrochimique. II s'agit par exemple d'un polyacétylène ou de polyanilines telles que l'Ormecon®. Ces dépôts, de l'ordre de 50 à 100nm, sont effectués directement sur le substrat transparent ou sur une couche intermédiaire par un grand nombre de techniques connues telles que la pulvérisation, l'évaporation, la technique sol-gel, ainsi que des techniques de dépôt en phase vapeur (CVD), dont on retiendra particulièrement le dépôt assisté par laser (LICVD).

En ce qui concerne la structuration des électrodes, il existe également différentes méthodes connues mises en oeuvre, en utilisant au moins un masque correspondant au contour des électrodes, soit lors du dépôt du TCO par cristallisation localisée d'un film sol-gel par irradiation avec un laser UV, soit en effectuant sur un film continu de TCO une attaque chimique, ou une ablation localisée en irradiant avec un laser UV à une fluence suffisante ou une ablation mécanique, comme décrit dans le brevet US 6 225 577. La nature du substrat transparent, verre ou plastique, est évidemment déterminante du point de vue technique et économique pour le choix du processus à appliquer. La cristallisation localisée d'un film sol-gel par laser UV n'est, par exemple, guère applicable à un substrat plastique, tel que le PMMA, car elle relève d'un processus photothermique.

D'autre part, l'emploi de composés chimiques très agressifs dans les procédés de gravage sélectif peut conduire à une dégradation du substrat ou d'une couche intermédiaire interposée entre ledit substrat et le film de TCO, telle que les espaces non conducteurs entre les électrodes peuvent encore rester perceptibles à l'oeil nu, quelle que soit la façon de garnir lesdits espaces non conducteurs. Ces espaces non conducteurs peuvent également être visibles en raison de la difficulté à les garnir sans former ni bourrelets, ni dépressions susceptibles de dévier les rayons lumineux, étant donné qu'il est nécessaire d'utiliser deux masques complémentaires, respectivement pour la gravure et pour le garnissage.

Pour pallier l'inconvénient sus-indiqué, le procédé proposé dans la demande européenne EP 1 457 865, au nom de la demanderesse, consiste à utiliser un unique masque en employant un rayonnement laser dont les caractéristiques (fluence, nombre d'impulsions, fréquence) sont ajustées selon deux modes différents pour deux étapes successives. La première étape consiste à éliminer totalement le TCO dans les espaces non conducteurs, et la deuxième étape à provoquer le dépôt d'un matériau d'indice de réfraction et d'épaisseur appropriés dans lesdits espaces. Il semblait en effet assez évident que deux électrodes proches l'une de l'autre ne pouvaient être isolées électriquement qu'en supprimant toute trace de matériau conducteur dans l'espace qui les sépare.

Il est toutefois apparu de façon surprenante que la conductivité électrique pouvait être abaissée à niveau si faible que deux électrodes proches soient isolées électriquement, sans pour autant éliminer le TCO, ce qui permet de maintenir les propriétés optiques initiales, et donc de rendre invisibles les contours des électrodes, quel que soit l'angle sous lequel on observe un substrat transparent comportant lesdites électrodes.

A cet effet, l'invention a pour objet un substrat transparent à électrodes invisibles comprenant un support transparent sur lequel est déposé un film transparent conducteur dans lequel des électrodes sont structurées avec des contours séparés par des espaces non conducteurs. Le substrat est caractérisé en ce que le film conducteur se trouvant à l'emplacement desdits espaces non conducteurs comporte des nanofissures dont le plus grand nombre traverse toute l'épaisseur du film conducteur en permettant d'interrompre la conductivité électrique entre électrodes voisines, sans modifier le trajet d'un rayon lumineux d'une façon perceptible à l'oeil nu. Les bords de ces nanofissures sont au plus écartées de quelques microns et ne peuvent être vus par un observateur dont l'acuité visuelle ne lui permet pas de distinguer, en vision rapprochée (20 - 30 cm), des objets distants de moins de 1/10 de millimètre.

Le film conducteur peut être un oxyde conducteur transparent (TCO), mais aussi un polymère conducteur transparent. Toutefois, dans la suite de la description on se référera essentiellement aux TCO qui sont les produits les plus connus pour réaliser des électrodes transparentes.

Dans un mode de réalisation préféré, préalablement au dépôt du film de TCO, le support transparent est revêtu d'une couche en un matériau dur transparent non conducteur (Hard coating) qui contribue à la formation des nanofissures.

Selon un autre mode de réalisation préféré, après la structuration des électrodes, toute la surface du substrat, c'est-à-dire les électrodes et les espaces non conducteurs, à l'exception éventuellement des zones de contact des électrodes, est recouverte d'un film protecteur, pouvant également avoir des propriétés anti-reflets et contribuant à stabiliser les nanofissures au cours du temps.

Les nanofissures dans la couche de TCO sont obtenues par irradiation UV au moyen d'une source laser. Pour cela, le procédé consiste à :
- placer le substrat, formé du support et du film de TCO éventuellement déposé sur une couche intermédiaire, dans une enceinte fermée ayant une amenée de fluide gazeux et une sortie de pompage;
- interposer, entre la source de rayonnement UV et le substrat, un masque comportant des fenêtres transparentes au rayonnement UV, lesdites fenêtres reproduisant les contours désirés des espaces non conducteurs, et
- en fonction des matériaux utilisés pour former le substrat, de leurs épaisseurs et du choix de la source émettrice, ajuster les caractéristiques du rayonnement pour provoquer une nanofissuration du film de TCO sans enlèvement de matière.

En ce qui concerne le choix de la source, on utilise de préférence un laser à excimère pulsé qui émet principalement dans l'ultraviolet et dont l'usage est connu pour effectuer de la photoablation ou du marquage. Il s'agit par exemple d'un excimère KrF (λ = 248 nm) à impulsions courtes (20 ns) ou d'un excimère XeF (λ = 308 nm) à impulsions longues (250 ns). Par "caractéristiques du rayonnement" on entend la fluence, le nombre d'impulsions et leur fréquence.

L'ajustement de ces caractéristiques doit s'effectuer entre une limite inférieure où on peut observer des fissures, mais sans baisse suffisante de la conductivité électrique, et une limite supérieure provoquant l'ablation de la couche de TCO rendant les contours des électrodes visibles, étant donné que l'espace isolant usuel entre les électrodes est de l'ordre de quelques dixièmes de millimètres. Il est évidemment possible, comme indiqué dans la demande européenne No 03005615.4 déjà citée, de garnir ces espaces avec un matériau diélectrique transparent permettant d'obtenir une compensation optique.

Le procédé selon l'invention présente donc l'avantage de ne pas nécessiter l'étape ci-dessus, et donc d'être plus économique. Il n'impose pas non plus le choix délicat d'un matériau diélectrique ayant un indice de réfraction et une épaisseur adaptés pour obtenir une compensation optique satisfaisante, compte tenu des caractéristiques propres du film de TCO (indice de réfraction et épaisseur).

Après la structuration des électrodes, il peut être avantageux de laisser le substrat dans l'enceinte, de remplacer le masque précédent par un autre masque dont la fenêtre transparente aux UV permet d'effectuer le dépôt d'un film protecteur transparent sur tout le substrat, c'est-à-dire les électrodes et les espaces non conducteurs, à l'exception éventuellement des zones de contact des électrodes, en introduisant un gaz précurseur dans l'enceinte. On choisit de préférence pour former le film protecteur un matériau dont la nature et l'épaisseur permettent d'avoir des propriétés anti-reflets. Le film présente également l'avantage de stabiliser les nanofissures dans le temps.

Ainsi, un substrat transparent à électrodes invisibles est utilisable dans toutes les applications citées en préambule en offrant des qualités de transparence et d'uniformité supérieures à celles des produits connus de l'art antérieur.

D'autres caractéristiques et avantages de la présente invention apparaîtront dans la description suivante, donnée à titre illustratif et non limitatif, en référence aux dessins annexés dans lesquels :
- la figure 1 est une représentation schématique d'un dispositif permettant d'obtenir un substrat transparent à électrodes invisibles selon l'invention;
- les figures 2 et 3 représentent les étapes de fabrication d'un premier mode de réalisation;
- les figures 4, 5 et 6 représentent les étapes de fabrication d'un deuxième mode de réalisation;
- la figure 7 représente le schéma de montage permettant d'effectuer des mesures électriques;
- la figure 8 est une vue d'une zone diélectrique nanofissurée selon l'invention;
- la figure 9 correspond à la figure 8 lorsque les caractéristiques du rayonnement UV sont insuffisantes;
- la figure 10 correspond à la figure 8 lorsque les caractéristiques du rayonnement UV sont au contraire excessives, et
- la figure 11 est une image AFM d'une nanofissure référencée à la figure 8.

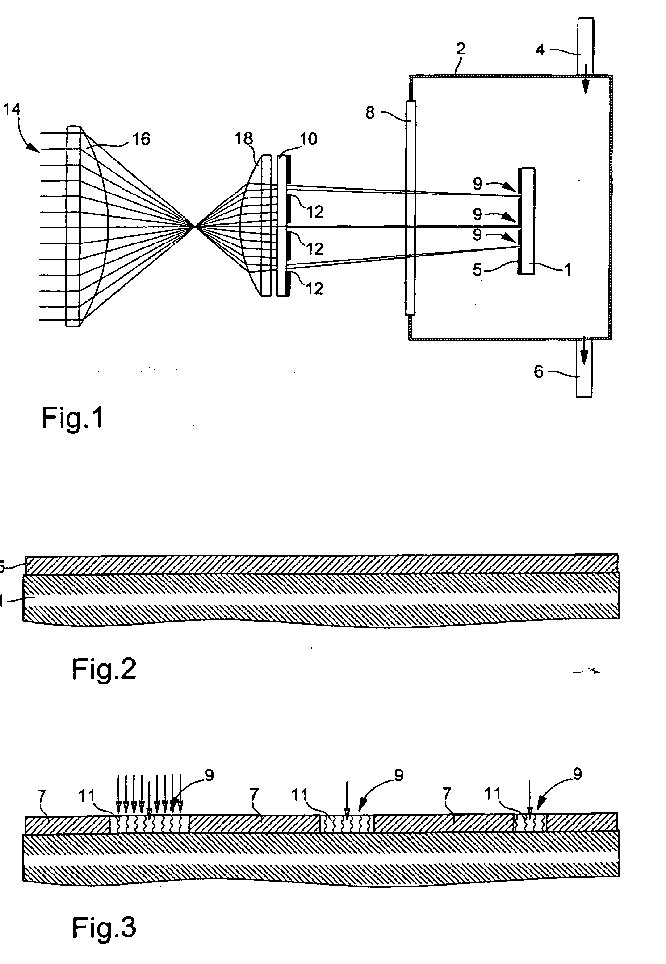

La figure 1 représente schématiquement le dispositif qui comporte fondamentalement une source 14 de rayonnement UV constituée par une source laser, une optique de type télescope comprenant une lentille convergente 16 et une lentille divergente 18 permettant de diminuer la section du faisceau laser afin d'en augmenter la fluence, un masque 10 comportant des zones 12 transparentes au rayonnement UV, et une enceinte 2. L'enceinte 2 comporte une fenêtre 8 transparente au rayonnement UV, une amenée 4 de gaz et une sortie 6 de pompage . L'enceinte 2 peut également comporter une amenée supplémentaire (non représentée) d'un gaz vecteur d'un gaz précurseur. A l'intérieur de l'enceinte 2 on a placé un substrat qui, dans cet exemple, comporte une base transparente qui est déjà revêtue d'un film 5 en TCO. Il serait évidemment possible, de former le film de TCO directement dans l'enceinte 2, par exemple par LICVD, mais d'un intérêt économique moindre, étant donné que la consommation d'énergie serait 100 fois supérieure.

La source de rayonnement UV est constituée par un laser eximère, tel qu'un laser XeF (308 nm) à impulsions longues (250 ns) fournissant une énergie maximale de 150 mJ par impulsion avec un faisceau rectangulaire de 1,9 x 2,4 cm², ou un laser KrF (248 nm) à impulsions courtes (20 ns) fournissant une énergie maximale de 180 mJ par impulsion avec un faisceau rectangulaire de 1,5 x 4 cm². D'autres lasers, par exemple un laser Nd:YAG triplé ou quadruplé, peuvent évidemment être utilisés, à condition d'en ajuster les caractéristiques au but recherché.

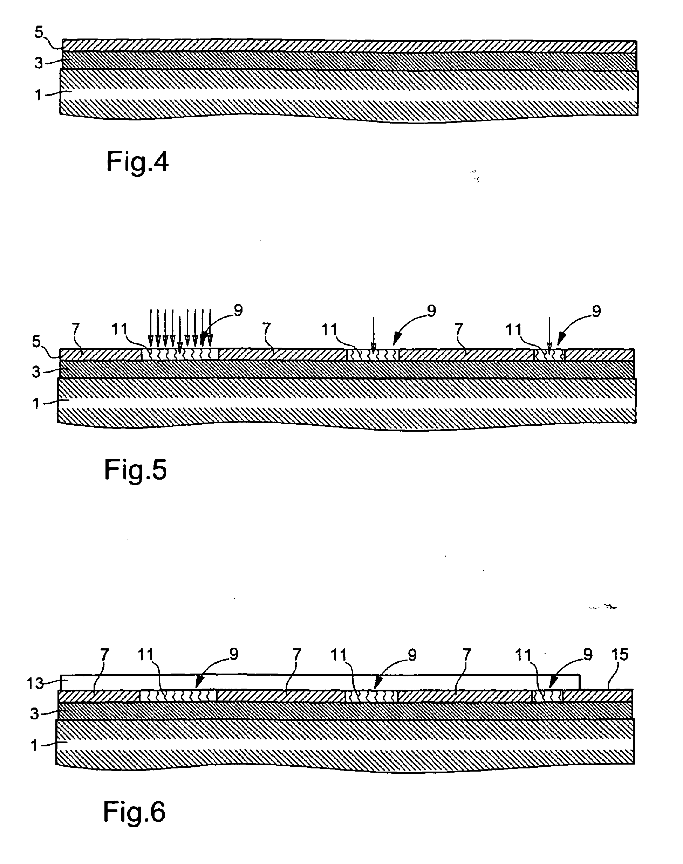

Les figures 2 et 3 correspondent au mode de réalisation le plus simple dans lequel un support 1 en un matériau transparent est revêtu d'un film continu de TCO, tel qu'un oxyde d'étain et d'indium (ITO) ayant dans cet exemple une épaisseur de 70 nm. Il serait bien évidemment possible d'utiliser un autre TCO, tel que In₂O₃ ou Sn O₂ dopé par Sb, et d'avoir une épaisseur différente comprise par exemple entre 50 et 100nm, de préférence entre 65 et 75 nm. Comme représenté à la figure 3, après irradiation UV dans l'enceinte 2, il se forme des espaces non conducteurs 9 crées par des nanofissures 11 traversant le film d'ITO et séparant électriquement les électrodes 7 et les zones de contact 15. Pour obtenir ces fissures et non l'ablation de l'ITO dans ces espaces d'électriques 9, il est nécessaire d'ajuster les caractéristiques du rayonnement UV dans des limites telles que la profondeur des nanofissures provoque une interruption de la conductivité suffisante pour isoler électriquement des électrodes voisines, sans pour autant provoquer une ablation de la couche d'ITO, comme cela est expliqué plus en détails pour le deuxième mode de réalisation correspondant aux figures 4 à 6.

A la figure 4, on voit que le substrat est constitué par un support 1, qui est dans cet exemple en PMMA, sur lequel est déposée une couche intermédiaire 3 en un matériau dur transparent non conducteur (hardcoating). Cette couche intermédiaire, qui protège le PMMA et qui contribue à stabiliser la base de l'ITO après nanofissuration, est par exemple composée d'une résine incorporant du SiO₂ et son épaisseur est de l'ordre de 20 µm. Ce substrat est placé dans l'enceinte 2, puis soumis à travers le masque 10 au rayonnement UV d'une source 14. Dans les exemples qui vont suivre, la source est constituée par un laser à eximère XeF (λ = 308 nm) à impulsions longues (250ns), avec comme caractéristiques d'illumination 20 impulsions à 5 Hz avec une surface illuminée de 3 x 4 mm², en faisant varier la fluence.

La figure 5 représente schématiquement la formation de nanofissures 11 créant les espaces non conducteurs 9 séparant les électrodes 7 et les zones de contact 15.

La figure 6 représente une étape optionnelle dans laquelle le substrat reste dans l'enceinte 2, mais où on a remplacé le masque 10 par un autre masque dont la fenêtre transparente au rayonnement délimite le contour utile du substrat transparent. On introduit alors dans l'enceinte par le conduit d'amenée 4 un gaz précurseur permettant le dépôt d'un film protecteur 13 en effectuant un nouveau réglage du caractéristiques du rayonnement UV. Le film 13 est par exemple constitué par un dépôt d'épaisseur uniforme de SiO₂ et TiO₂ éventuellement modifié pour avoir des propriétés anti-reflets. Le film 13 permet aussi d'une part de stabiliser les nanofissures 11 dans le temps, d'autre part de rendre les électrodes encore moins visibles en garnissant les espaces entre les nanofissures.

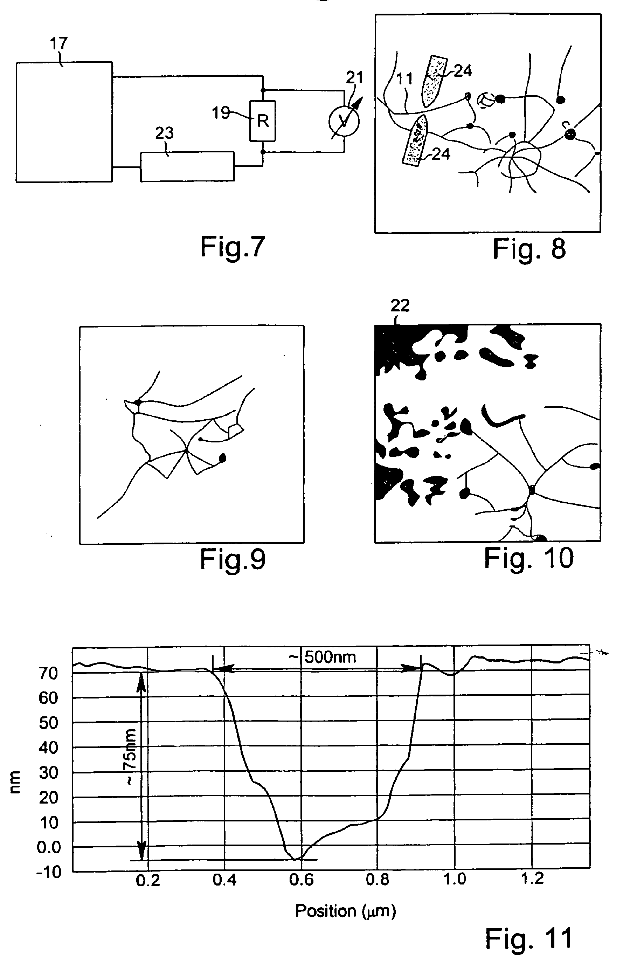

Les figures 7 à 11 montrent sur des exemples comment il convient d'ajuster les caractéristiques du rayonnement UV. Pour cela on a pris trois échantillons identiques comportant une couche intermédiaire ayant une épaisseur de 20 µm sur laquelle on a déposé un film d'ITO de 70 nm d'épaisseur et on a illuminé une surface de 3 x 4 mm avec un laser à excimère à 308 nm à impulsions longues avec 20 impulsions à 5 Hz, en faisant varier la fluence.

Le schéma représenté à la figure 7 correspond à un montage permettant de mesurer les caractéristiques électriques des échantillons dans la zone illuminée. Un générateur 17 délivre une tension sinusoïdale de 1,77 V à un circuit comprenant en série une résistance 19 calibrée entre 2,2 k Ω et 570 k Ω et une portion de l'échantillon 23, ce qui permet de déduire des valeurs de courant comprises entre 0,7 m A et 0,2 µ A en mesurant au moyen d'un voltamètre 21 la tension aux bornes de la résistance 19. (R_{ech.} = (V_{gen}.-V)/I). La "portion d'échantillon 23" est prise entre deux pointes 24 distantes de 0,3 à 0,5 mm de part et d'autre d'une nanofissure, comme représenté à la figure 8. On peut également utiliser une extrémité en forme de boucle (non représentée), c'est-à-dire d'avoir un contact adouci pour éviter la détérioration du film d'ITO par les pointes.

Lorsque l'échantillon n'a subi aucune irradiation UV, la résistance entre pointes est de 180 Ω pour un courant traversant l'échantillon de 1,5 mA avec une résistance calibrée de 670 Ω.

A la figure 8 on a redessiné l'image observée, par microscopie en réflexion avec un grossissement d'environ 15 fois, après irradiation avec un faisceau laser ayant les caractéristiques précitées et une fluence de 65 mJ/cm². On observe que les nonofissures sont nombreuses. En effectuant les mêmes mesures électriques que pour l'échantillon non illuminé avec la même distance entre pointes de mesure le courant alternatif n'est plus mesurable («0,2 µA), ce qui signifie que les plages d'ITO situées de part et d'autre de la fissure 11 sont suffisamment isolées électriquement.

Cela est confirmé par l'imagerie AFM faite à travers une nanofissure et représentée à la figure 11. On voit que la nanofissure a une profondeur maximale de 75 nm, c'est-à-dire que la base de ladite nanofissure pénètre très légèrement dans le hardcoating isolant 3 faisant que les bords inférieurs de la nanofissure sont séparés électriquement par environ 70 nm. On voit également qu'à la partie supérieure la largeur maximale de la nanofissure 11 est de l'ordre de 500 nm, c'est-à-dire une largeur beaucoup trop faible pour pouvoir être décelée à l'oeil nu.

En effectuant sur un deuxième échantillon la même irradiation mais avec une fluence plus faible, à savoir de 60 mJ/cm², on obtient également des fissures, comme représenté à la figure 9, mais avec une faible variation des caractéristiques électriques. Avec une résistance initiale de 670 Q, on observe une résistance entre pointes de 800 Ω et un courant de 1,19 mA signifiant qu'il existe encore une conductivité importante au niveau de la fissure. Par imagerie AFM (non représentée) on peut en effet déterminer que la profondeur maximale de la fissure est de 66 nm, c'est-à-dire qu'il reste une jonction de conduction électrique à la base de la fissure.

Inversement, en se référant à la figure 10, on voit qu'en augmentant la fluence de 65 mJ/cm² à 70 mJ/cm², il se forme des zones 22 dans lesquelles le film d'ITO est arraché sur une largeur suffisante pour rendre la zone séparant les électrodes visible à l'oeil nu. La conductivité électrique est évidemment interrompue, mais il est alors nécessaire d'effectuer une étape de fabrication complémentaire pour obtenir une compensation optique, par exemple selon le procédé proposé dans la demande EP No 1 457 865 déjà citée.

Il est bien évident que l'homme de métier peut, en fonction d'une part de la nature du film de TCO, voire de celle de la couche intermédiaire et de leurs épaisseurs respectives, définir les caractéristiques du rayonnement UV en fonction de la source laser utilisée pour se situer entre une limite inférieure où l'interruption de conductivité électrique est insuffisante et une limite supérieure où il se produit un arrachage de TCO.

Ainsi on peut, dans les mêmes conditions de mesures que celles décrites en référence à la figure 8 obtenir les mêmes résultats concernant la conductivité électrique lorsque la zone irradiée à une surface de 1 x 4 mm² avec une fluence de 85 mJ/cm².

En utilisant un laser à 248 nm, impulsions courtes, on obtient également le résultat correspondant à la figure 8 avec un échantillon de 2 x 8 mm², avec 50 impulsions à 5 Hz et une fluence de 50 mJ/cm².

En fonction de la source laser utilisée qui n'est pas limité à un laser à eximère, l'homme de métier peut donc facilement, par quelques essais préliminaires, déterminer les conditions optimales permettant de provoquer des nanofissures sans enlèvement de matière, mais de façon suffisante pour interrompre la conductivité électrique entre électrodes.

## Revendications

1. Substrat transparent à électrodes invisibles comprenant un support (1) transparent sur lequel est déposé un film conducteur transparent (5) **caractérisé en ce que** des fissures (11) dont la largeur maximale est inférieure à l'acuité visuelle humaine sont incorporées dans le film conducteur transparent (5) afin de définir des espaces non conducteurs (9) propres à structurer de manière non visibles dans ledit film conducteur transparent des électrodes (7) et leurs zones de contact (15).

2. Substrat selon la revendication 1, **caractérisé en ce que** le film conducteur transparent (5) est un oxyde transparent conducteur (TCO), choisi parmi un oxyde d'étain et d'indium (ITO), In₂O₃ et SnO₂ dopé par Sb.

3. Substrat selon la revendication 2, **caractérisé en ce que** le film conducteur transparent (5) est un film d'ITO ayant une épaisseur comprise entre 50 et 100 nm, de préférence entre 65 et 75 nm.

4. Substrat selon la revendication 1, **caractérisé en ce que** le film conducteur transparent (5) est un polymère conducteur dopé à doubles liaisons conjuguées choisi parmi un polyacetylène et de polyanilines.

5. Substrat selon l'une des revendications précédentes, **caractérisé en ce qu'**une couche intermédiaire (3) en un matériau dur transparent non conducteur est interposée entre le support (1) et le film conducteur transparent (5).

6. Substrat selon la revendication 5, **caractérisé en ce que** la couche intermédiaire (3) est composée d'une résine incorporant du SiO₂, et ayant une épaisseur au moins égale à 20 µm.

7. Substrat selon l'une des revendications précédentes, **caractérisé en ce que** la majorité des fissures (11) traverse tout le film conducteur.

8. Substrat selon l'une des revendications précédentes, **caractérisé en ce que** le support (1) est réalisé en un matériau choisi parmi le polyméthylène méthacrylate (PMMA) et le polycarbonate (PC).

9. Substrat selon l'une quelconque des revendications précédentes, **caractérisé en ce que** les électrodes (7) et les espaces non conducteurs (9) sont en outre recouverts d'un film protecteur (13) pouvant également avoir des propriétés anti-reflets, ledit film protecteur (13) ne recouvrant pas les zones de contact (15) des électrodes (7).

10. Substrat selon l'une des revendications précédentes, **caractérisé en ce qu'**il constitue un écran tactile de commande d'un appareil électronique dans lequel il est intégré.

11. Substrat selon l'une des revendications 1 à 9, **caractérisé en ce qu'**il constitue au moins une plaque de fermeture d'une cellule d'affichage à cristaux liquides ou d'une cellule photovoltaïque d'un appareil électronique.

12. Procédé de fabrication d'un substrat transparent à électrodes invisibles comprenant un support (1) transparent sur lequel est déposé un film conducteur transparent (5) dans lequel des électrodes (7) sont structurées avec des contours séparés par des espaces non conducteurs (9) par irradiation UV au moyen d'une source de rayonnement (14), **caractérisé en ce qu'**il consiste en les étapes suivantes :
- placer le substrat, formé du support (1) et du film conducteur transparent (5), éventuellement déposé sur une couche intermédiaire (3) en un matériau dur transparent non conducteur, dans une enceinte (2) fermée ayant une amenée (4) de fluide gazeux et une sortie (6) de pompage;
- interposer, entre la source de rayonnement UV (14) et le substrat, un masque (10) comportant des fenêtres (12) transparentes au rayonnement UV, lesdites fenêtres correspondant aux espaces non conducteurs (9), et
- ajuster, en fonction du choix des matériaux du substrat et de la source émettrice (14), les caractéristiques du rayonnement UV pour provoquer une fissuration du film conducteur transparent (5) dont la largeur maximale est inférieure à l'acuité visuelle humaine dans la zone irradiée.

13. Procédé selon la revendication 12, **caractérisé en ce qu'**il comporte une étape supplémentaire consistant à effectuer le dépôt d'un film protecteur (13), éventuellement anti-reflet, à partir d'un gaz précurseur avec la même source UV (14), mais en remplaçant le masque (10) utilisé par un autre masque correspondant à la surface utile souhaitée pour le substrat transparent en laissant apparentes les zones de contact (15) des électrodes (7).

14. Procédé selon la revendication 12, **caractérisé en ce que** le film conducteur transparent (5) est un oxyde transparent conducteur (TCO) choisi parmi un oxyde d'étain et d'indium (ITO), In₂O₃ et SnO₂ dopé par Sb.

15. Procédé selon la revendication 12, **caractérisé en ce que** le film conducteur transparent (5) est un polymère conducteur dopé choisi parmi un polyacétylène et des polyanilines.

16. Procédé selon la revendication 12, **caractérisé en ce que** la source UV (14) est constituée par un laser à excimère choisi parmi les lasers XeF à impulsions longues et KrF à impulsions courtes.

## Claims

1. Transparent substrate with invisible electrodes including a transparent support (1) on which there is deposited a transparent conductive film (5),
**characterized in that** fissures (11) whose maximum width is less than the human acuteness of vision are incorporated in the transparent conductive film (5) in order to define non-conductive spaces (9) appropriate to structure in a non visible manner in said transparent conductive film electrodes (7) and their contact zones (15).

2. Substrate according to claim 1, **characterized in that** the transparent conductive film (5) is a transparent conductive oxide (TCO), selected from the group comprising tin and indium oxide (ITO), In₂O₃ and SnO₂ doped with Sb.

3. Substrate according to claim 2, **characterized in that** the conductive film (5) is an ITO film having a thickness comprised between 50 and 100 nm, preferably between 65 and 75 nm.

4. Substrate according to claim 1, **characterized in that** the transparent conductive film (5) is a doped conductive polymer with conjugated double bonds selected from among a polyacetylene and polyanilines.

5. Substrate according to any of the preceding claims, **characterized in that** an intermediate layer (3) made of a transparent hard non-conductive material or hardcoating is inserted between the support (1) and the transparent conductive film (5).

6. Substrate according to claim 5, **characterized in that** the intermediate layer (3) is formed of a resin incorporating SiO₂ and having a thickness at least equal to 20 µm.

7. Substrate according to any of the preceding claims, **characterized in that** the majority of the fissures (11) pass through the entire conductive film.

8. Substrate according to any of the preceding claims, **characterized in that** the support (1) is made of a material selected from among polymethylene methacrylate (PMMA) and polycarbonate (PC).

9. Substrate according to any one of the preceding claims, **characterized in that** the electrodes (7) and the non-conductive spaces (9) are further coated with a protective film (13) also able to have anti-reflective properties, said protective film (13) not covering the contact zones (15) of the electrodes (7).

10. Substrate according to any of the preceding claims, **characterized in that** it forms a touch-type control screen for an electronic apparatus in which it is integrated.

11. Substrate according to any of claims 1 to 9, **characterized in that** it forms at least one closing plate for a liquid crystal display cell or a photovoltaic cell for an electronic apparatus.

12. Method of manufacturing a transparent substrate with invisible electrodes including a transparent support (1) on which there is deposited a transparent conductive film (5) wherein electrodes (7) are structured with contours separated by non-conductive spaces (9), by UV radiation by means of a radiation source (14),
**characterized in that** it comprises of the following steps:
- placing the substrate, formed of the support (1) and the transparent conductive film (5) possibly deposited on an intermediate layer (3) made of a transparent hard non-conductive material, in a sealed enclosed space (2) having a gaseous fluid supply inlet (4) and a pump outlet (6);
- inserting, between the UV radiation source (14) and the substrate, a mask (10) including windows (12) transparent to UV radiation, said windows corresponding to the non-conductive spaces (9), and
- adjusting, as a function of the choice of materials used for the substrate and the emitting source (14), the UV radiation features to cause fissures to be created in the transparent conductive film (5) whose maximum width is less than the human acuteness of vision in the radiated zone.

13. Method according to claim 12, **characterized in that** it includes an additional step of depositing a conductive film (13), which may be anti-reflective, from a precursor gas with the same UV source (14), but replacing the mask (10) used by another mask corresponding to the desired useful surface of the transparent substrate, while leaving the contact zones (15) of the electrodes (7) visible.

14. Method according to claim 12, **characterized in that** the transparent conductive film (5) is a transparent conductive oxide (TOC) selected from the group comprising tin and indium oxide (ITO), In₂O₃ and SnO₂ doped with Sb.

15. Method according to claim 12, **characterized in that** the transparent conductive film (5) is a doped conductive polymer selected from among a polyacetylene and polyanilines.

16. Method according to claim 12, **characterized in that** the source (14) is formed by an excimer laser selected from among XeF long pulse lasers and KrF short pulse lasers.

## Patentansprüche

1. Transparentes Substrat mit unsichtbaren Elektroden, welches einen transparenten Träger (1) umfasst, auf dem eine transparente leitfähige Folie (5) abgelegt ist, **dadurch gekennzeichnet, dass** Fissuren (11), deren maximale Breite kleiner ist als die menschliche Sehschärfe, in die leitfähige transparente Folie (5) eingefügt sind, um nicht leitfähige Bereiche (9) zu definieren, welche geeignet sind, auf nicht sichtbare Weise in der leitfähigen transparenten Folie Elektroden (7) und deren Kontaktzonen (15) zu strukturieren.

2. Substrat nach Anspruch 1, **dadurch gekennzeichnet, dass** die leitfähige transparente Folie (5) ein transparentes leitfähiges Oxyd (TCO) ist, welches gewählt ist aus einem Zinn- und Indiumoxyd (ITO), In₂O₃ und SnO₂ dotiert mit Sb.

3. Substrat nach Anspruch 2, **dadurch gekennzeichnet, dass** die leitfähige transparente Folie (5) eine ITO-Folie mit einer Dicke zwischen 50 und 100 nm, vorzugsweise zwischen 65 und 75 nm, ist.

4. Substrat nach Anspruch 1, **dadurch gekennzeichnet, dass** die transparente leitfähige Folie (5) ein leitfähiges Polymer ist, das mit konjugierten Doppelbindungen dotiert ist, gewählt aus einem Polyacetylen und Polyanilinen.

5. Substrat nach einem der vorgehenden Ansprüche, **dadurch gekennzeichnet, dass** eine Zwischenschicht (3) aus einem harten transparenten nicht leitfähigem Material zwischen dem Träger (1) und der transparenten leitfähigen Folie (5) angeordnet ist.

6. Substrat nach Anspruch 5, **dadurch gekennzeichnet, dass** die Zwischenschicht (3) aus einem Harz besteht, welches SiO₂ enthält, und eine Dicke von wenigstens 20 µm besitzt.

7. Substrat nach einem der vorstehenden Ansprüche, **dadurch gekennzeichnet, dass** die Mehrzahl der Fissuren (11) die gesamte leitfähige Folie quert.

8. Substrat nach einem der vorstehenden Ansprüche, **dadurch gekennzeichnet, dass** der Träger aus einem Material hergestellt ist, welches gewählt ist aus Polymethylmethacrylat (PMMA) und Polykarbonat (PC).

9. Substrat nach einem der vorstehenden Ansprüche, **dadurch gekennzeichnet, dass** die Elektroden (7) und die nicht leitfähigen Bereiche (9) ferner mit einer Schutzfolie (13) bedeckt sind, welche auch Antireflexeigenschaften haben kann, wobei die Schutzfolie (13) die Kontaktbereiche (15) der Elektroden (7) nicht bedeckt.

10. Substrat nach einem der vorstehenden Ansprüche, **dadurch gekennzeichnet, dass** es einen Touchscreen zum Steuern eines elektronischen Gerätes bildet, in welches es integriert ist.

11. Substrat nach einem der Ansprüche 1 bis 9, **dadurch gekennzeichnet, dass** es wenigstens eine Abschlussplatte einer Anzeigezelle mit Flüssigkristallen oder einer photovoltaischen Zelle eines elektronischen Gerätes bildet.

12. Verfahren zum Herstellen eines transparenten Substrates mit unsichtbaren Elektroden, welches einen transparenten Träger (1) umfasst, auf dem eine leitfähige transparente Folie (5) aufgebracht ist, in der mit Hilfe einer Strahlungsquelle (14) durch UV-Strahlung Elektroden (7) mit Konturen strukturiert sind, die über nicht leitfähige Bereiche (9) voneinander getrennt sind, **dadurch gekennzeichnet, dass** es aus folgenden Verfahrungsschritten besteht :
- Anordnen des Substrates, gebildet von dem Träger (1) und der eventuell auf einer Zwischenschicht (3) aus einem harten, transparenten, nicht leitfähigen Material angeordneten transparenten leitfähigen Folie (5), in einem geschlossenen Raum (2), der eine Zufuhr (4) für ein gasförmiges Fluid und einen Ausgang (6) zum Pumpen aufweist;
- Auflegen einer Maske (10), welche für UV Strahlung durchlässige Fenster (12) umfasst, zwischen der UV Strahlungsquelle (14) und dem Substrat, wobei die Fenster den nichtleitfähigen Bereichen (9) entsprechen, und
- justieren der Eigenschaften der UV-Strahlung in Abhängigkeit von der Wahl der Materialen des Substrates und der Strahlungsquelle (14), um die Bildung von Fissuren in der transparenten leitfähigen Folie (5) in dem bestrahlten Bereich zu provozieren, deren maximale Breite kleiner ist als die menschliche Sehschärfe.

13. Verfahren nach Anspruch 12, **dadurch gekennzeichnet, dass** es einen zusätzlichen Verfahrungsschritt umfasst, welcher darin besteht, eine Schutzfolie (13), eventuell mit Antireflexeigenschaften, aufzutragen, ausgehend von einem Vorläufergas und mit der gleichen UV Quelle (14), aber unter Ersetzung der verwendeten Maske (10) durch eine Maske, die der gewünschten Nutzoberfläche für das transparente Substrat entspricht, und die Kontaktbereiche (15) der Elektroden (7) frei lässt.

14. Verfahren nach Anspruch 12, **dadurch gekennzeichnet, dass** die leitfähige transparente Folie (5) ein leitfähiges transparentes Oxyd (TCO) ist, welches ausgewählt ist aus einem Zinn- und Indiumoxyd (ITO), In₂O₃ und SnO₂ dotiert mit Sb.

15. Verfahren nach Anspruch 12, **dadurch gekennzeichnet, dass** die leitfähige transparente Folie (5) ein dotiertes leitfähiges Polymer ist, ausgewählt aus einem Polyacetylen und Polyanilinen.

16. Verfahren nach Anspruch 12, **dadurch gekennzeichnet, dass** die UV-Quelle (14) von einem Eximerlaser gebildet ist, der gewählt ist aus einem XeF - Laser mit langen Impulsen und einem KrF - Laser mit kurzen Impulsen.
